(19) Europäisches Patentamt / European Patent Office / Office européen des brevets

(11) **EP 2 337 220 A1**

(12) **DEMANDE DE BREVET EUROPEEN**

(43) Date de publication:
**22.06.2011 Bulletin 2011/25**

(51) Int Cl.:
*H03H 7/40* (2006.01)     *H04B 1/04* (2006.01)

(21) Numéro de dépôt: **10192971.9**

(22) Date de dépôt: **29.11.2010**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **18.12.2009 FR 0959246**

(71) Demandeur: **STMicroelectronics (Tours) SAS
37100 Tours (FR)**

(72) Inventeurs:
• **Charley, Sylvain
37390, METTRAY (FR)**
• **Dupont, François
37000, TOURS (FR)**
• **Bonnet, Benoît
37100, TOURS (FR)**

(74) Mandataire: **de Beaumont, Michel
1bis, rue Champollion
38000 Grenoble (FR)**

(54) **Evaluation d'une impédance de charge en sortie d'un coupleur directif**

(57) L'invention concerne un procédé et un circuit d'évaluation d'une impédance de charge en sortie d'un coupleur directif (4) dont une première ligne (41) est destinée à véhiculer un signal utile entre une première borne (42) et une deuxième borne (44) destinée à être connectée à une antenne (2), et dont une seconde ligne (43) couplée à la première comporte une troisième borne (46) côté première borne et une quatrième borne (48) côté deuxième borne, dans lequel le signal présent sur la quatrième borne est soumis à un détecteur homodyne (60) dont le signal d'oscillateur local est prélevé sur la troisième borne.

Fig 3

**Description**

Domaine de l'invention

La présente invention concerne de façon générale des circuits électroniques et, plus particulièrement, les circuits d'émission-réception radiofréquence.

L'invention s'applique plus particulièrement à des circuits équipés d'un coupleur pour extraire une information relative aux pertes en réflexion côté antenne et, plus généralement, relative à une impédance de charge en sortie d'un coupleur directif.

Exposé de l'art antérieur

Les chaînes d'émission-réception radiofréquence intègrent généralement des coupleurs. Un coupleur est utilisé pour prélever une partie de la puissance présente sur une ligne de transmission, dite principale ou primaire, vers une autre ligne, dite couplée ou secondaire, située à proximité.

Les coupleurs se répartissent en deux catégories selon qu'ils sont constitués de composants passifs discrets (on parle alors de coupleur à éléments localisés) ou de lignes conductrices proches l'une de l'autre pour être couplées (on parle alors de coupleur à lignes distribuées). L'invention concerne les deux catégories de coupleurs.

Dans de nombreuses applications, on a besoin de prélever une partie de la puissance transmise sur une ligne, par exemple, pour contrôler la puissance d'un amplificateur dans un circuit d'émission, pour contrôler la linéarité d'un amplificateur d'émission en fonction des pertes liées à la réflexion d'une antenne, pour adapter dynamiquement une antenne, pour régler un réseau d'adaptation d'impédance, etc. Une mesure de l'amplitude (et parfois de la phase) des signaux présents sur les bornes de la ligne secondaire sert à prélever cette information.

De plus en plus souvent, les appareils électroniques communiquant (par exemple les téléphones mobiles ou les ordinateurs portables) sont susceptibles de fonctionner sur des gammes de fréquence différentes (par exemple GSM et WLAN). Ils sont alors généralement équipés de plusieurs antennes. De plus, ces circuits d'émission-réception sont susceptibles de fonctionner en même temps. Or, les antennes ne sont pas parfaitement isolées les unes par rapport aux autres. Il en découle un risque qu'une antenne capte les émissions d'une autre bande de fréquences avec un niveau non-négligeable par rapport au signal utile.

Cela pose un problème dans l'utilisation des coupleurs. En particulier, en présence d'un coupleur directif dont le rôle est généralement de mesurer les pertes en réflexion côté antenne (donc un éventuel défaut d'adaptation), le niveau du signal parasite provenant d'une autre bande de fréquences est susceptible d'être supérieur au niveau du signal utile, faussant ainsi la mesure.

Pour résoudre ce problème, une solution actuelle est d'associer à la ligne secondaire du coupleur des démodulateurs des signaux présents sur ses bornes. Une telle démodulation permet d'éliminer la bande de fréquences parasite et de calculer correctement les pertes en réflexion. Toutefois, le coût de cette démodulation est élevé.

Il serait souhaitable d'améliorer la fiabilité des mesures effectuées par un coupleur à moindre coût.

Le document US-A-2009/0253385 décrit un réseau d'adaptation d'impédance d'antenne dans lequel un coupleur directif a une ligne principale reliant un amplificateur à l'antenne par l'intermédiaire d'un circuit d'adaptation d'impédance, et une ligne couplée dont la borne côté antenne est reliée à un circuit de conversion. Ce circuit de conversion comporte un circuit d'oscillateur local générant des fréquences à destination du circuit de conversion. Un tel circuit requiert un synthétiseur de fréquence.

Le document JP-A-2007-166534 décrit un circuit de réception comportant également un circuit de génération d'une fréquence d'oscillateur local.

Résumé

Un objet d'un mode de réalisation de la présente invention est de pallier tout ou partie des inconvénients des systèmes d'émission-réception radiofréquence usuels.

Un objet d'un mode de réalisation de la présente invention vise plus particulièrement à améliorer la fiabilité d'un coupleur directif.

Un objet d'un mode de réalisation de la présente invention vise à s'affranchir des perturbations provenant d'émissions dans d'autres bandes de fréquences, notamment sur la mesure de l'impédance de charge en sortie d'un coupleur directif.

Un objet d'un mode de réalisation de la présente invention vise également à éviter une démodulation des signaux mesurés par les circuits usuels de réception présents dans la chaîne radiofréquence.

Pour atteindre tout ou partie de ces objets ainsi que d'autres, il est prévu un circuit d'évaluation d'une impédance de charge en sortie d'un coupleur directif dont une première ligne est destinée à véhiculer un signal utile entre une première borne et une deuxième borne destinée à être connectée à une antenne, et dont une seconde ligne couplée à la première comporte une troisième borne côté première borne et une quatrième borne côté deuxième borne, le circuit comportant :

une première borne d'entrée destinée à être connectée à ladite troisième borne du coupleur ;
une seconde borne d'entrée destinée à être connectée à la quatrième borne du coupleur ;
un détecteur homodyne dont une première entrée de signal à traiter est reliée à ladite deuxième borne d'entrée et dont une deuxième entrée d'oscillateur local est reliée à ladite première borne d'entrée ;
un premier filtre passe-bas dont une entrée est reliée à une première sortie du détecteur homodyne et qui fournit une première information relative à l'impédance de charge ; et
un second filtre passe-bas dont une entrée est relié à une seconde sortie du détecteur homodyne et qui fournit une deuxième information relative à l'impédance de charge.

Selon un mode de réalisation de la présente invention, un premier amplificateur à gain variable est intercalé entre ladite seconde borne d'entrée du circuit et ladite première entrée du détecteur homodyne, le gain étant réglé en fonction du niveau de signal reçu sur ladite première entrée du circuit.

Selon un mode de réalisation de la présente invention, un détecteur logarithmique est intercalé entre ladite première borne d'entrée du circuit et ladite seconde entrée du détecteur homodyne, une sortie dudit détecteur étant reliée à une entrée de commande de gain dudit amplificateur.

Selon un mode de réalisation de la présente invention, le détecteur homodyne comporte :

un premier multiplieur dont deux entrées sont respectivement reliées aux première et seconde entrées du détecteur, et dont une sortie est reliée à la première sortie du détecteur fournissant ladite première information ; et
un deuxième multiplieur dont deux entrées sont respectivement reliées directement à la première entrée du détecteur et, par l'intermédiaire d'un déphaseur de 90°, à la seconde entrée du détecteur, et dont une sortie est reliée à la seconde sortie du détecteur.

Selon un mode de réalisation de la présente invention, une troisième information relative à l'amplitude de l'impédance de charge est obtenue en calculant la racine carrée de la somme d'élévations au carré des première et seconde informations.

Selon un mode de réalisation de la présente invention, une quatrième information relative à la phase de l'impédance de charge est obtenue en calculant l'arctangente du rapport entre la deuxième et la première information.

On prévoit également un circuit d'émission-réception radiofréquence comportant :

un coupleur directif dont une première ligne est destinée à véhiculer un signal utile entre une première borne et une deuxième borne destinée à être connectée à une antenne, et dont une seconde ligne couplée à la première comporte une troisième borne côté première borne et une quatrième borne côté deuxième borne ; et
un circuit d'évaluation d'une impédance de charge en sortie du coupleur directif, les première et deuxième bornes d'entrée du circuit étant respectivement reliées aux troisième et quatrième bornes du coupleur.

On prévoit également un procédé d'évaluation d'une impédance de charge en sortie d'un coupleur directif dont une première ligne est destinée à véhiculer un signal utile entre une première borne et une deuxième borne destinée à être connectée à une antenne, et dont une seconde ligne couplée à la première comporte une troisième borne côté première borne et une quatrième borne côté deuxième borne, dans lequel :

le signal présent sur la quatrième borne est soumis à un détecteur homodyne dont le signal d'oscillateur local est prélevé sur la troisième borne.

Selon un mode de réalisation de la présente invention :

le signal présent sur la quatrième borne est multiplié par le signal présent sur la troisième borne, puis soumis à un filtrage passe-bas pour fournir une première information relative à l'impédance de charge ; et
le signal présent sur la troisième borne est déphasé de 90°, puis multiplié par le signal présent sur la quatrième borne, le résultat de la multiplication étant soumis à un filtrage passe-bas pour fournir une deuxième information relative à l'impédance de charge.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1 est un schéma bloc d'un mode de réalisation d'un circuit d'émission-réception radiofréquence ;
la figure 2 représente, de façon très schématique, un coupleur associé à un circuit de détection usuel ;
la figure 3 représente, de façon très schématique, un coupleur associé à un circuit de détection selon un mode de réalisation de la présente invention ; et
les figures 4A, 4B et 4C illustrent le fonctionnement du circuit de détection de la figure 3.

Description détaillée

De mêmes éléments ont été désignés par de mêmes références aux différentes figures. Pour des raisons de clarté, seuls les éléments utiles à la compréhension de l'invention ont été représentés et seront décrits. En particulier, la génération et l'exploitation des signaux émis et reçus par le circuit d'émission-réception radio-fréquence n'ont pas été détaillées, l'invention étant compatible avec les traitements usuels. De plus, l'exploitation faite des mesures de l'impédance de charge côté antenne n'a pas n'ont plus été détaillée, l'invention étant là encore compatible avec les utilisations usuelles de ces informations, que ce soit pour adapter la puissance d'un amplificateur d'émission, régler un réseau d'adaptation d'impédance, etc.

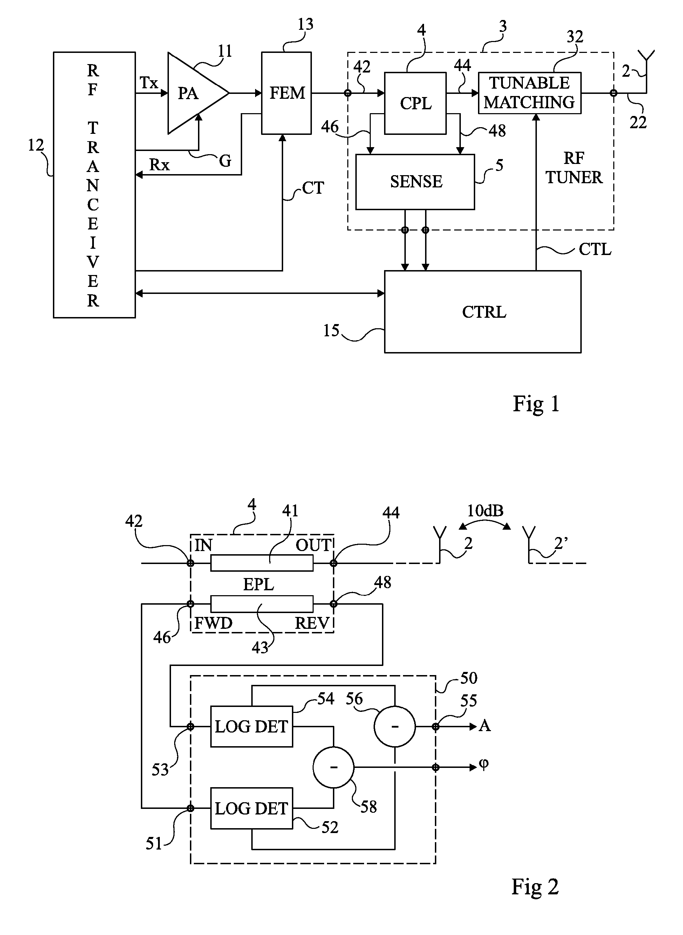

La figure 1 est un schéma bloc d'un exemple de réalisation d'un circuit d'émission-réception radiofréquence du type auquel s'applique la présente invention.

Ce circuit est destiné à fonctionner dans une gamme de fréquences donnée, par exemple, une des bandes de communication GSM. Un amplificateur d'émission 11 reçoit, d'un circuit électronique de traitement 12 (RF TRANCEIVER), un signal Tx à émettre. Ce signal, amplifié par l'amplificateur 11, est destiné à être appliqué sur une borne 22 d'une antenne 2 après avoir traversé une chaîne de traitement. Dans l'exemple de la figure 1, cette chaîne comporte un module terminal 13 (Front End Module FEM) et un syntoniseur radiofréquence 3 (RF TUNER). Le module 13 constitue un commutateur d'antenne et a pour rôle de séparer les signaux émis des signaux reçus par l'antenne. Le module 13 fournit au circuit 12 un signal Rx reçu. Par ailleurs, le module 13 reçoit un ou plusieurs signaux de commande CT du circuit 12.

Le syntoniseur 3 comporte, entre autres, un coupleur 4 (CPL) et un circuit 32 d'adaptation d'impédance (TUNABLE MATCHING) dont le rôle est d'adapter l'impédance de l'antenne 2 en temps réel en fonction des perturbations susceptibles d'être présentes.

Le coupleur 4 a pour rôle de restituer, sur des bornes secondaires 46 et 48 d'une ligne secondaire, des informations proportionnelles aux signaux transitant sur une ligne principale dont des bornes 42 et 44 sont respectivement connectées en sortie du module 13 et en entrée du réseau d'adaptation 32. Les bornes 46 et 48 de la ligne secondaire sont reliées à un circuit 5 de détection (SENSE) destiné, dans cet exemple, à fournir une information sur les pertes en réflexion côté antenne 2 à un circuit 15 de commande (CTRL) du réseau d'adaptation d'impédance 32. Le circuit 15 échange des informations avec le circuit 12 et fournit un signal de commande CTL au réseau 32. Les informations extraites de la ligne secondaire du coupleur 4 peuvent également servir à commander une antenne réglable en impédance ou, par l'intermédiaire du circuit 12, le gain G dans l'amplificateur d'émission 11.

Le cas échéant, les positions respectives du syntoniseur 3 et du commutateur d'antenne 13 sont inversées. Dans ce cas, deux syntoniseurs sont présents respectivement pour l'émission et pour la réception.

Par ailleurs, d'autres circuits sont susceptibles d'équiper un circuit d'émission-réception radiofréquence tel qu'illustré en figure 1, par exemple, des filtres, d'autres coupleurs ou d'autres éléments d'adaptation d'impédance. De plus, les liaisons entre les différents éléments ont été, pour simplifier, représentés monofilaires. Plusieurs signaux peuvent toutefois transiter entre les différents éléments, par exemple pour véhiculer d'autres informations ou commandes, ou pour véhiculer des signaux différentiels.

La figure 2 représente de façon schématique le coupleur 4 du syntoniseur RF de la figure 1 associé à un circuit 50 de détection usuel. Les autres éléments du circuit de la figure 1 n'ont pas été illustrés en figure 2.

Le coupleur 4 est par exemple un coupleur en lignes distribuées et comporte une ligne principale 41 dont des extrémités définissent les bornes 42 et 44 (généralement désignées IN et OUT). La ligne 41 est couplée à une ligne secondaire 43 dont des extrémités FWD (ou CPLD) et REV (ou ISO), respectivement en regard des extrémités IN et OUT, définissent les bornes 46 et 48. La ligne secondaire 43 prélève une partie de la puissance transitant sur la ligne principale 41 à des fins de mesure. La proportion de la puissance prélevée définit le couplage (généralement entre 20 et 40 dB).

Les principaux paramètres d'un coupleur sont :

les pertes d'insertion qui représentent la perte de transmission entre les deux accès de la ligne principale (les pertes d'insertion se définissent alors que les deux autres ports du coupleur sont chargés par une impédance de 50 ohms) ;

le couplage qui représente la perte de transmission entre les ports IN et CPLD (le couplage se définit alors que les deux autres ports OUT et ISO sont chargés par une impédance de 50 ohms) ;

l'isolation qui représente la perte de transmission entre les ports IN et ISO (l'isolation se définit alors que les deux autres ports OUT et CPLD sont chargés par une impédance de 50 ohms) ; et

la directivité qui représente la différence de pertes en transmission entre les ports ISO et CPLD, depuis le port IN.

La directivité représente donc la différence en puissance (exprimée en dB) entre les deux accès de la ligne couplée ou secondaire. Un coupleur idéal présente une directivité infinie, c'est-à-dire qu'aucune puissance n'est présente sur le port de sa ligne secondaire située en regard du port de sortie OUT de sa ligne principale quand un signal circule sur cette ligne principale du port d'entrée IN vers le port de sortie OUT. En pratique, un coupleur est dit directif quand sa directivité est suffisante pour que les puissances récupérées sur les ports de sa ligne secondaire permettent de distinguer le sens de circulation de la puissance dans la ligne principale.

Les modes de réalisation qui vont être décrits concernent les coupleurs directifs dans lesquels les signaux présents sur les bornes CPLD et ISO ne présentent pas les mêmes niveaux. Si ces coupleurs sont symétriques, ils sont alors bidirectionnels, c'est-à-dire que, de la même manière qu'un signal appliqué sur la borne IN est couplé sur la borne FWD (CPLD), un signal appliqué sur la borne OUT est couplé au niveau de la borne REV (ISO).

En supposant que le coupleur est attaqué par un signal à émettre sur la borne IN, la majeure partie de ce signal est transmise vers l'antenne 2. Une faible partie du signal (dont la puissance dépend du couplage) se retrouve sur la borne FWD. On considère qu'un coupleur présente une bonne directivité si elle est d'au moins 20 dB. Avec un couplage d'environ -30 dB (ce qui correspond à prélever 1/1000 de la puissance transmise), l'isolation est alors de l'ordre de -50 dB, ce qui est acceptable et une partie négligeable du signal émis se retrouve sur la borne REV. Pour simplifier l'exposé qui suit, on supposera que le coupleur présente une directivité infinie.

Dans l'exemple de la figure 2, on souhaite évaluer les pertes en réflexion côté antenne 2, c'est-à-dire la proportion du signal émis qui est réfléchie par l'antenne. Pour cela, on mesure la différence entre l'amplitude du signal présent sur la borne FWD et l'amplitude du signal présent sur la borne REV qui est proportionnelle à l'amplitude du signal retourné par l'antenne. Le couplage conditionne l'amplitude du signal présent sur la borne REV par rapport à l'amplitude réfléchie par l'antenne sur la borne OUT.

Le circuit 50 de détection comporte deux bornes d'entrée 51 et 53 respectivement connectées aux bornes 46 et 48 et a pour rôle de calculer la différence d'amplitude et parfois de phase entre les signaux présents sur les bornes FWD et REV. Typiquement, le circuit 50 comporte deux détecteurs logarithmiques 52 et 54 (LOG DET) déterminant l'amplitude des signaux présents sur les bornes 51 et 53. Les amplitudes mesurées sont soustraites l'une à l'autre (plus précisément l'amplitude fournie par le détecteur 54 est soustraite de celle fournie par le détecteur 52) pour obtenir l'amplitude A des pertes en réflexion sur une borne 55 de sortie du circuit 50. Optionnellement, la phase $\phi$ du signal réfléchi par rapport au signal émis est également calculée par un soustracteur 58 exploitant une information de phase fournie par les détecteurs 52 et 54. La dynamique des détecteurs logarithmiques dépend de l'amplitude des signaux attendus. On utilise généralement des détecteurs logarithmiques ayant une dynamique de 40 à 60 dB.

En prenant pour exemple un coupleur 4 présentant une directivité infinie et un couplage de -30 dB, un signal appliqué sur la borne IN va être transmis sur la borne OUT (avec une atténuation négligée correspondant aux pertes d'insertion). En supposant des pertes en réflexion de -10 dB, un signal de +15 dBm appliqué sur la borne IN est transmis à l'antenne et la borne OUT voit revenir un signal réfléchi avec un niveau de +5 dBm. Côté ligne secondaire, en raison du couplage, le signal présent sur la borne FWD a une amplitude de -15 dBm. On suppose, par exemple, que le coupleur est symétrique de sorte que le couplage entre les bornes OUT et REV est identique au couplage entre les bornes IN et FWD. Par conséquent, le signal présent sur la borne REV a une amplitude de -25 dBm. Le calcul de la différence entre les amplitudes présentes sur les bornes FWD et REV fournit bien l'information sur les pertes en réflexion, soit -10 dB.

Toutefois, dans certaines circonstances, le signal présent sur la borne OUT peut être influencé par d'autres paramètres que les pertes en réflexion de l'antenne. C'est notamment le cas si l'antenne 2 capte un signal provenant d'une autre voie d'émission. Or, de plus en plus souvent, les dispositifs de communication mobiles sont susceptibles de communiquer sur plusieurs bandes de fréquences et possèdent ainsi plusieurs antennes qui, de surcroît, peuvent émettre simultanément. Par exemple, l'équipement comporte un autre circuit d'émission-réception associé à une antenne 2' (pour simplifier, le reste du circuit d'émission n'a pas été illustré en figure 2). L'influence d'un circuit sur l'autre dépend alors de l'isolation entre les antennes. Or, cette isolation n'est jamais parfaite. Il en découle que lorsque le circuit d'émission associé à l'antenne 2' fonctionne en même temps que celui associé à l'antenne 2, cette dernière capte des signaux provenant de l'autre bande de fréquences. Même atténués par l'isolation entre les antennes, ces signaux sont susceptibles de perturber la mesure des pertes en réflexion par le détecteur 50. En supposant une isolation de 10 dB entre les antennes 2 et 2', et que l'antenne 2' reçoit un niveau de +20 dBm de son circuit d'émission, l'antenne 2 capte un signal parasite avec un niveau de +10 dBm. En reprenant les valeurs de couplage et de directivité précédente, ce signal va se retrouver avec un niveau de -20 dBm sur la borne REV (couplage de -30 dB). Ce signal parasite présente donc une amplitude supérieure à celle (-25 dBm) du signal utile à la mesure des pertes en réflexion sur la borne REV. Il en découle une mesure erronée, le détecteur 50 estimant alors les pertes en réflexion à -5 dB alors qu'elles sont de -10 dB. Cela conduit à une mauvaise adaptation de l'antenne et à une dégradation de la communication.

Ce problème est particulièrement présent pour des dispositifs mobiles de communication intégrant plusieurs circuits susceptibles de fonctionner à des fréquences différentes ou lorsque deux dispositifs mobiles de communication sont très près l'un de l'autre (par exemple un téléphone mobile placé à proximité d'un ordinateur portable communiquant). Il faut généralement être en présence de telles conditions pour que l'amplitude du signal parasite soit supérieure à celle du signal utile. En effet, s'il s'agit de signaux environnants (émis depuis une source lointaine), ils sont généralement d'un niveau nettement inférieur.

On aurait pu penser filtrer le signal présent sur la borne REV pour éliminer la composante due à la bande de fréquences non souhaitée. Toutefois, les signaux parasites peuvent se retrouver en bande proche de celle du signal utile, nécessitant des filtres acoustiques (SAW ou BAW) en raison de la forte atténuation requise. Là encore, cela conduirait à une solution onéreuse et encombrante.

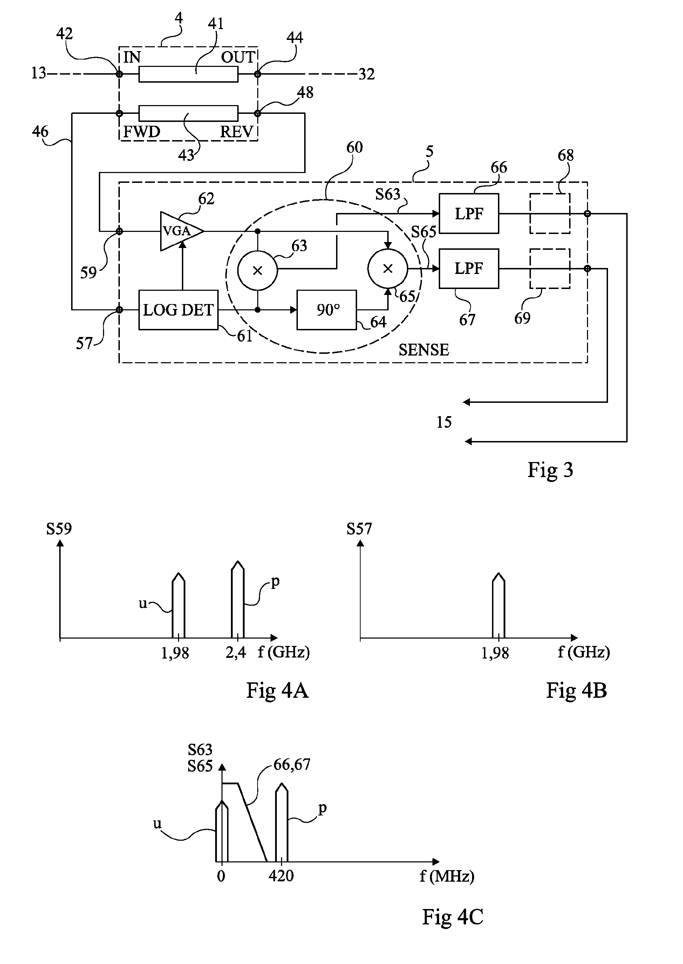

La figure 3 représente un mode de réalisation d'un circuit 5 de détection associé à un coupleur 4 pour extraire des informations d'amplitude et optionnellement de phase des pertes en réflexion. Les autres éléments du circuit d'émission-réception n'ont pas été illustrés en figure 5 et sont, par exemple, identiques à ceux de la figure 1.

Le détecteur 5 est basé sur un détecteur ou récepteur homodyne 60, c'est-à-dire utilisant une démodulation à base d'un oscillateur local à même fréquence que le signal à mesurer pour extraire les informations d'amplitude et de phase. Un tel détecteur est également appelé détecteur à fréquence intermédiaire nulle. Selon ce mode de réalisation, on tire profit de la présence, sur la borne 46 du coupleur, d'un signal dans la bande de fréquence utile que l'on souhaite détecter côté borne REV, pour l'utiliser comme fréquence d'oscillateur local du détecteur homodyne.

On aurait pu penser utiliser comme oscillateur local une fréquence provenant du circuit d'émission (12, figure 1). Toutefois, la fréquence utilisée par le circuit d'émission doit rester la plus propre (moins perturbée) possible pour permettre une modulation correcte du signal à émettre. Cette fréquence risquerait d'être perturbée si elle était véhiculée jusqu'au syntoniseur 3. En particulier, la distance entre le circuit de transmission 12 et le syntoniseur 3 n'est généralement pas négligeable (du même ordre de grandeur que la longueur d'onde du signal utile). Il en découle que côté syntoniseur, l'oscillateur local de l'émetteur radiofréquence n'est pas disponible.

Dans le mode de réalisation de la figure 3, la borne 46 du coupleur 4 est reliée à une première borne 57 du détecteur, reliée en entrée d'un détecteur logarithmique 61. La borne 48 du coupleur est reliée à une deuxième borne d'entrée 59 connectée en entrée d'un amplificateur 62. De préférence, cet amplificateur est à gain ajustable (VGA - Variable Gain Amplifier), commandé par le détecteur logarithmique 61 en fonction de l'amplitude reçue sur la borne 57, de façon à normaliser la mesure et à étendre la dynamique de réception.

Les signaux fournis par le détecteur logarithmique 61 et l'amplificateur 62 sont traités par le détecteur homodyne 60. Un premier multiplieur 63 multiplie les signaux fournis par le détecteur 61 et par l'amplificateur 62 et fournit une première information S63. Par ailleurs, la sortie du détecteur 61 traverse un élément déphaseur 64 de 90° dont la sortie est multipliée (multiplieur 65) par la sortie de l'amplificateur 62 pour fournir une deuxième information S65. Par rapport à un détecteur homodyne usuel, une différence est d'utiliser le signal présent sur la borne FWD en guise d'oscillateur local.

La multiplication du signal présent sur la borne REV par le signal utile ramène, en bande de base, la portion réfléchie par l'antenne qui correspond à l'émission par le circuit 12. Les signaux reçus par l'antenne dans d'autres bandes sont décalés en fréquence de la valeur de la fréquence d'oscillateur local. En pratique, comme le signal est modulé, ce décalage souffre de l'imprécision lié à la plage de modulation. Cet effet est toutefois négligeable par rapport à l'écart entre les bandes de fréquences.

Le détecteur 5 comporte en outre deux filtres passe-bas 66 et 67 destinés à éliminer la contribution des signaux des bandes de fréquence parasites. Utiliser un détecteur homodyne permet de ramener les signaux utiles en bande de base, ce qui facilite le filtrage. Les signaux fournis par les filtres 66 et 67 sont exploités par le circuit de commande (15, figure 1).

Les figures 4A, 4B et 4C illustrent le fonctionnement du détecteur 5 de la figure 3. Les figures 4A et 4B illustrent la distribution en fréquence des signaux S57 et S59 présents sur les bornes d'entrée 57 et 59 du détecteur 5. La figure 4C illustre la distribution en fréquence en sortie S63 ou S65 du détecteur homodyne 60.

On suppose que le circuit d'émission-réception associé au détecteur 5 est destiné à véhiculer des signaux de téléphonie mobile WCDMA (par exemple, autour d'une fréquence de 1,98 GHz) et que les perturbations proviennent d'une antenne émettant dans la plage de fréquence WLAN (autour de 2,4 GHz). Comme l'illustre la figure 4A, le signal présent sur la borne 59 comporte une portion utile u autour de 1,98 GHz et une portion parasite p autour de 2,4 GHz. On illustre en figure 4A que le niveau de la portion p autour de 2,4 GHz est supérieure à celui de la portion utile u.

Le signal présent sur la borne 57 (figure 4B) est uniquement autour de la fréquence de 1,98 GHz.

La figure 4C illustre la répartition en fréquence des signaux S63 et S65. La portion utile u se retrouve en bande de base (autour de OHz), tandis que la portion parasite p est ramenée autour de 420 MHz (2,4 GHz - 1,98 GHz).

La modulation autour des fréquences centrales 1,98 et 2,4 n'est pas gênante dans la mesure où la plage de modulation est limitée (typiquement de quelques à quelques dizaines de MHz). Les portions du signal ne se chevauchent donc pas.

La fréquence de coupure des filtres 66 et 67 est choisie en fonction des fréquences susceptibles de venir perturber le signal utile. En tout état de cause, le fait d'avoir ramené les signaux utiles en bande de base diminue considérablement la fréquence de coupure et facilite ainsi la réalisation des filtres, par exemple avec des composants passifs.

Le rôle de l'amplificateur 62 est de normaliser les amplitudes et d'étendre la dynamique de démodulation des deux voies en fonction de l'amplitude sur la borne 57.

En notant :

$\omega_u$ la pulsation du signal utile ;
$A_f$ l'amplitude du signal utile présent sur la borne FWD ;
$\omega_p$ la pulsation du signal parasite ;
Ap l'amplitude de ce signal parasite ;
$A_r$ l'amplitude du signal présent sur la borne REV à la pulsation $\omega_u$ ;
$\phi_r$ la phase du signal utile sur la borne REV ;
$\phi_p$ la phase du signal parasite sur la borne REV ;
G1 le gain de l'amplificateur 62, fixé de préférence à partir de l'amplitude détectée par le détecteur 61 ; et
G2 le gain du détecteur logarithmique 61, fixé à la fabrication,

on peut établir les relations suivantes :

$$S57 = A_f*\cos(\omega_u t) \ ;$$

$$S59 = A_r*\cos(\omega_c t+\phi r) + A_P*\cos(\omega_p t+\phi_p) \ ;$$

$$S62 = A_r*G1*\cos(\omega_u t+\phi_r) + Ap*G1*\cos(\omega_p t + \phi_p) \ ;$$

$$S61 = A_f*G2\cos(\omega_u t) \ ;$$

$$S65 = A_f*G2\sin(\omega_u t) \ ;$$

$$S66 = A_r*G1*A_f*G2*\cos(\phi_r) \ ;$$

et

$$S67 = A_r*G1*A_f*G2*\sin(\phi_r).$$

Les informations S66 et S67 fournies par les filtres 66 et 67 permettent de déduire l'amplitude et la phase du signal réfléchi dans la bande de fréquences exploitée par le coupleur. Cette amplitude et cette phase peuvent être calculées par le circuit 15 ou, en variante, par des éléments de calcul 68 et 69 illustrés en pointillés en figure 3.

L'amplitude $A_r$ est donnée par la relation :

$$A_r = \sqrt{S66^2 + S67^2}.$$

La phase $\phi_r$ est donnée par la relation :

EP 2 337 220 A1

$$\phi_r = \text{arctan}(S67/S66).$$

On notera que l'amplitude mesurée est indépendante de la différence de phase. Toutefois, il subsiste sur la phase mesurée une ambiguïté sur le sens du déphasage. Cette ambiguïté n'est pas gênante dans les applications visées.

Le détecteur décrit ci-dessus est compatible avec d'autres bandes de fréquence même inférieures à la bande utile. Par exemple, si une autre antenne émet autour d'une fréquence GSM à 900 MHz et que la bande utile est autour de 1,98 GHz, on assistera à un repliement de ces fréquences autour de 900 MHz qui en sortie du détecteur homodyne se retrouveront aux alentours de 900 MHz et pourront alors être filtrées.

Par ailleurs, le détecteur décrit est capable d'éliminer les contributions de plusieurs bandes parasites pourvu que ces bandes ne chevauchent pas la modulation de la bande utile.

Divers modes de réalisation ont été décrits, diverses variantes et modifications apparaîtront à l'homme de l'art. En particulier, la réalisation pratique du détecteur est à la portée de l'homme du métier à partir des indications fonctionnelles données ci-dessus et des plages de fréquences utile et parasites. De plus, bien que l'invention ait été décrite en relation avec un exemple de coupleur directif symétrique en lignes distribuées, elle s'applique plus généralement à tout coupleur directif, qu'il soit ou non symétrique et qu'il soit en lignes distribuées ou à éléments localisés.

## Revendications

1. Circuit d'évaluation d'une impédance de charge en sortie d'un coupleur directif (4) dont une première ligne (41) est destinée à véhiculer un signal utile entre une première borne (42) et une deuxième borne (44) destinée à être connectée à une antenne (2), et dont une seconde ligne (43) couplée à la première comporte une troisième borne (46) côté première borne et une quatrième borne (48) côté deuxième borne, le circuit (5) comportant :

   une première borne d'entrée (57) destinée à être connectée à ladite troisième borne du coupleur ;
   une seconde borne d'entrée (59) destinée à être connectée à la quatrième borne du coupleur ;
   un détecteur homodyne (60) dont une première entrée de signal à traiter est reliée à ladite deuxième borne d'entrée et dont une deuxième entrée d'oscillateur local est reliée à ladite première borne d'entrée ;
   un premier filtre passe-bas (66) dont une entrée est reliée à une première sortie du détecteur homodyne et qui fournit une première information (S66) relative à l'impédance de charge ; et
   un second filtre passe-bas (67) dont une entrée est relié à une seconde sortie du détecteur homodyne et qui fournit une deuxième information (S67) relative à l'impédance de charge.

2. Circuit selon la revendication 1, dans lequel un premier amplificateur à gain variable (62) est intercalé entre ladite seconde borne d'entrée (59) du circuit (5) et ladite première entrée du détecteur homodyne (60), le gain étant réglé en fonction du niveau de signal reçu sur ladite première entrée (57) du circuit.

3. Circuit selon la revendication 2, dans lequel un détecteur logarithmique (61) est intercalé entre ladite première borne d'entrée (57) du circuit (5) et ladite seconde entrée du détecteur homodyne, une sortie dudit détecteur étant reliée à une entrée de commande de gain dudit amplificateur (62).

4. Circuit selon la revendication 3, dans lequel le détecteur homodyne (60) comporte :

   un premier multiplieur (63) dont deux entrées sont respectivement reliées aux première et seconde entrées du détecteur, et dont une sortie est reliée à la première sortie du détecteur fournissant ladite première information (S66) ; et
   un deuxième multiplieur (65) dont deux entrées sont respectivement reliées directement à la première entrée du détecteur et, par l'intermédiaire d'un déphaseur de 90° (64), à la seconde entrée du détecteur, et dont une sortie est reliée à la seconde sortie du détecteur.

5. Circuit selon la revendication 4, dans lequel une troisième information relative à l'amplitude de l'impédance de charge est obtenue en calculant la racine carrée de la somme d'élévations au carré des première et seconde informations.

6. Circuit selon la revendication 5, dans lequel une quatrième information relative à la phase de l'impédance de charge est obtenue en calculant l'arc tangente du rapport entre la deuxième et la première information.

**7.** Circuit d'émission-réception radiofréquence comportant :

un coupleur directif (4) dont une première ligne (41) est destinée à véhiculer un signal utile entre une première borne (42) et une deuxième borne (44) destinée à être connectée à une antenne (2), et dont une seconde ligne (43) couplée à la première comporte une troisième borne (46) côté première borne et une quatrième borne (48) côté deuxième borne ; et
un circuit (5) d'évaluation d'une impédance de charge en sortie du coupleur directif, conforme à l'une quelconque des revendications 1 à 6, les première (57) et deuxième (59) bornes d'entrée du circuit étant respectivement reliées aux troisième (46) et quatrième (48) bornes du coupleur.

**8.** Procédé d'évaluation d'une impédance de charge en sortie d'un coupleur directif (4) dont une première ligne (41) est destinée à véhiculer un signal utile entre une première borne (42) et une deuxième borne (44) destinée à être connectée à une antenne (2), et dont une seconde ligne (43) couplée à la première comporte une troisième borne (46) côté première borne et une quatrième borne (48) côté deuxième borne, dans lequel :

le signal présent sur la quatrième borne est soumis à un détecteur homodyne (60) dont le signal d'oscillateur local est prélevé sur la troisième borne.

**9.** Procédé selon la revendication 8, dans lequel :

le signal présent sur la quatrième borne est multiplié par le signal présent sur la troisième borne, puis soumis à un filtrage passe-bas pour fournir une première information (S66) relative à l'impédance de charge ; et
le signal présent sur la troisième borne est déphasé de 90° (64), puis multiplié (65) par le signal présent sur la quatrième borne, le résultat de la multiplication étant soumis à un filtrage passe-bas (67) pour fournir une deuxième information (S67) relative à l'impédance de charge.

Fig 1

Fig 2

Fig 3

Fig 4A

Fig 4B

Fig 4C

Europäisches
Patentamt

European
Patent Office

Office européen
des brevets

**RAPPORT DE RECHERCHE EUROPEENNE**

Numéro de la demande

EP 10 19 2971

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/253385 A1 (DENT PAUL WILKINSON [US] ET AL) 8 octobre 2009 (2009-10-08) * abrégé; figures 4,7,8,14 * * alinéas [0012], [0040], [0043] - [0045], [0047], [0048], [0050], [0051], [0054], [0055], [0062], [0064] * ----- | 1-9 | INV. H03H7/40 H04B1/04 |
| X | JP 2007 166534 A (MATSUSHITA ELECTRIC IND CO LTD) 28 juin 2007 (2007-06-28) * abrégé; figures 1,2 * * alinéas [0011] - [0018] * ----- | 1-9 | |
| A | FR 2 928 508 A1 (STMICROELECTRONICS TOURS SAS S [FR]) 11 septembre 2009 (2009-09-11) * le document en entier * ----- | 1-9 | |
| | | | DOMAINES TECHNIQUES RECHERCHES (IPC) G01R H04B H03H |

Le présent rapport a été établi pour toutes les revendications

| Lieu de la recherche | Date d'achèvement de la recherche | Examinateur |
|---|---|---|
| Berlin | 4 mars 2011 | Binger, Bernard |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 19 2971

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-03-2011

| Document brevet cité au rapport de recherche | | Date de publication | Membre(s) de la famille de brevet(s) | | Date de publication |
|---|---|---|---|---|---|
| US 2009253385 | A1 | 08-10-2009 | AU<br>EP<br>WO | 2009235501 A1<br>2272170 A1<br>2009124874 A1 | 15-10-2009<br>12-01-2011<br>15-10-2009 |
| JP 2007166534 | A | 28-06-2007 | AUCUN | | |
| FR 2928508 | A1 | 11-09-2009 | US | 2010022203 A1 | 28-01-2010 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090253385 A
- JP 2007166534 A